# EUROPÄISCHE PATENTSCHRIFT

(11) **EP 1 510 118 B1**
(45) Veröffentlichungstag und Bekanntmachung des Hinweises auf die Patenterteilung: **08.08.2007**
(21) Anmeldenummer: 03756958.9
(22) Anmeldetag: 02.06.2003
(51) Int. Cl.: H05K 13/08

(54) **VERFAHREN ZUR VERMESSUNG DER VERZERRUNG EINER FLÄCHEN-POSITIONIERVORRICHTUNG**
METHOD FOR MEASURING THE DEFORMATION OF A SURFACE POSITIONING DEVICE
PROCÉDÉ POUR MESURER LA DISTORSION D'UN DISPOSITIF DE POSITIONNEMENT SUR UNE SURFACE

(30) Priorität: 05.06.2002 DE 10224993
(43) Veröffentlichungstag der Anmeldung: 02.03.2005
(73) Patentinhaber: SIEMENS AKTIENGESELLSCHAFT, 80333 München (DE)
(72) Erfinder: PRÜFER, Martin, 81379 München (DE)
(86) Internationale Anmeldenummer: PCT/DE2003/001817
(87) Internationale Veröffentlichungsnummer: WO 2003/105557

(56) Entgegenhaltungen:
- EP-A- 0 326 236
- WO-A-99/10136
- US-A- 5 105 368
- PATENT ABSTRACTS OF JAPAN vol. 017, no. 688 (P-1662), 16. Dezember 1993 (1993-12-16) & JP 05 233065 A (MATSUSHITA ELECTRIC IND CO LTD), 10. September 1993 (1993-09-10)

## Beschreibung

Die Erfindung betrifft ein Verfahren zur Vermessung der Verzerrung einer Flächen-Positioniervorrichtung, insbesondere einer für einen Bestückautomaten verwendeten Positioniervorrichtung.

Aufgrund der zunehmenden Miniaturisierung von elektronischen Bauelementen müssen moderne Bestückautomaten neben einer hohen Bestückleistung auch eine große Bestückgenauigkeit aufweisen, damit die zu bestückenden Bauelemente möglichst genau an einer vorgegebenen Position auf einer Leiterplatte bzw. auf einem Substrat aufgesetzt werden und somit eine schlechte oder eine fehlende Kontaktierung zwischen Bauelement und Leiterplatte verhindert wird. Sogenannte Fine-Pitch-Bauelemente, bei denen die metallischen Kontaktanschlüsse in einem Abstand von deutlich weniger als 1 mm voneinander angeordnet sind, müssen zur Vermeidung von schlechten Kontakten beispielsweise mit einer Genauigkeit aufgesetzt werden, so dass die IstPosition des Bauelements von der Soll-Position des Bauelements um maximal 50 µm abweicht. Eine derart hohe Bestückgenauigkeit lässt sich allerdings nicht durch die mechanische Präzision der verwendeten Flächen-Positioniervorrichtung des Bestückautomaten allein erreichen. Aus diesem Grund werden mechanische Abweichungen, welche beispielsweise durch Fertigungsschwankungen oder durch sonstige Verspannungen von einzelnen oder mehreren Komponenten der Positioniervorrichtung verursacht werden, durch eine entsprechende Vorsteuerung in der den Bestückprozess steuernden Software kompensiert. Eine zuverlässige Kompensation der mechanischen Abweichungen der in dem Bestückautomaten verwendeten Positioniervorrichtung erfordert demzufolge vor dem eigentlichen Bestückvorgang eine präzise Vermessung der Verzerrung der Positioniervorrichtung.

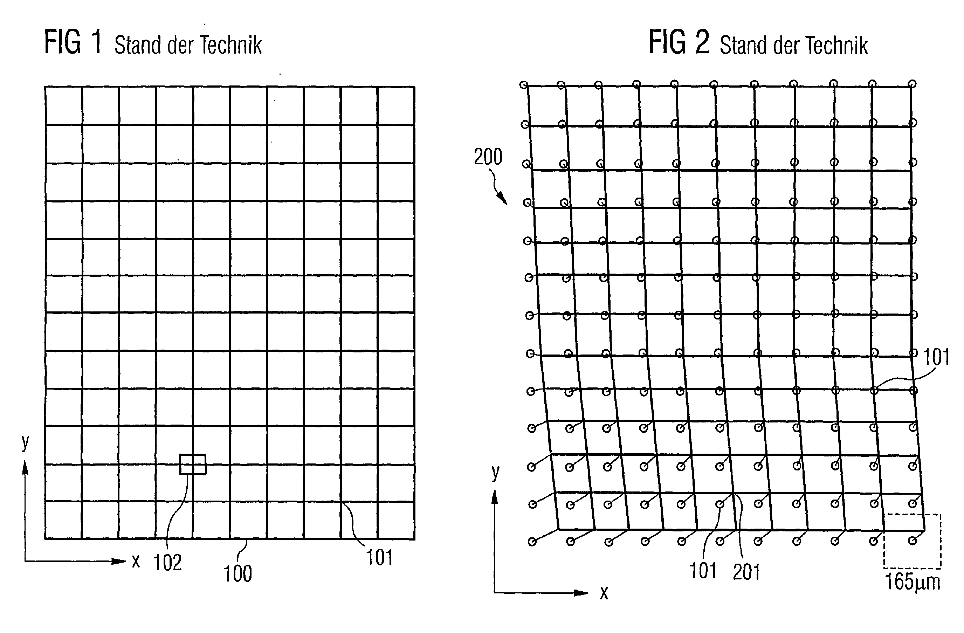

Wie in Figur 1 dargestellt, erfolgt gemäß dem Stand der Technik die Vermessung der Verzerrung der Positioniervorrichtung unter Verwendung einer sog. Referenzplatte 100, auf welcher eine Mehrzahl von Referenzmarken 101 angebracht sind. Die Referenzmarken 101 sind bevorzugt mit einer hohen räumlichen Genauigkeit auf einem regelmäßigen zweidimensionalen Raster aufgebracht, welches durch eine X-Richtung und eine dazu senkrechte Y-Richtung definiert ist. Die US-A-5 105 368 offenbart ein solches Verfahren.

Die Referenzplatte 100 ist bevorzugt aus einem Material mit einem geringen thermischen Ausdehnungskoeffizienten gefertigt, so dass der relative Abstand der Referenzmarken 101 zueinander selbst bei unterschiedlichen Umgebungstemperaturen möglichst gleich bleibt. Aus diesem Grund sind die meisten Referenzplatten 100 aus einem Glas mit geringem thermischen Ausdehnungskoeffizienten gefertigt. Die Referenzmarken 101 sind dann durch ein Ätzverfahren oder durch eine mechanische Bearbeitung der Referenzplatte 100 an der Glasplatte angebracht. Somit wird auf einfache Weise ein hoher optischer Kontrast zwischen der Referenzplatte 100 und der an der Referenzplatte 100 angebrachten Referenzmarken 101 erreicht.

Es wird darauf hingewiesen, dass die Referenzplatte 100 nicht unbedingt mit einer hohen Präzision gefertigt sein muss. Zur genauen Vermessung einer Flächen-Positioniervorrichtung genügt auch eine ungenau gefertigte Referenzplatte 100, welche allerdings zuvor mittels einer getrennten Messmaschine genau vermessen wurde, so dass die räumliche Lage der Referenzmarken 101 genau bekannt ist.

Um in einem bestimmten Bestückbereich, in welchem eine Leiterplatte bestückt werden soll, die Verzerrung der Positioniervorrichtung zu vermessen, werden gemäß dem Stand der Technik die an der Referenzplatte 100 in einem äquidistanten Raster von beispielsweise 40 mm x 40 mm oder 20 mm x 20 mm angebrachten Referenzmarken 101 vermessen. Die Vermessung erfolgt üblicherweise mittels einer Kamera, welche an dem Arm der Flächen-Positioniervorrichtung angebracht ist und welche die Referenzplatte 100 in einem Kamera-Erfassungsbereich 102 erfasst. Anhand des für die Erfassung der Referenzmarken 101 erforderlichen Verfahrweges der Positioniervorrichtung wird für jede Referenzmarke 101 jeweils eine Messposition bestimmt. Aus dem vektoriellen Abstand zwischen der Messposition und der a priori genau bekannten Position der Referenzmarke 101 wird ein resultierender Differenzvektor berechnet. Die Differenzvektoren für alle erfassten Referenzmarken 101 werden dann in einem sog. Fehlerresiduen-Feld 200 gespeichert, welches in Figur 2 dargestellt ist. In dem Fehlerresiduen-Feld 200 stellt jeder Differenzvektor die lokale Verzerrung 201 der Flächen-Positioniervorrichtung an der entsprechenden Stelle des Bestückbereiches dar.

Es wird darauf hingewiesen, dass in Figur 2 die lokalen Verzerrungen 201 nicht maßstabsgetreu, sondern vergrößert dargestellt sind. Diese Vergrößerung ist durch das gestrichelt gezeichnete Quadrat angedeutet, welches in dem Fehlerresiduen-Feld 200 unten rechts dargestellt ist. Die Kantenlänge des gestrichelten Quadrats von 166 µm verdeutlicht den Maßstab für die eingezeichneten Differenzvektoren.

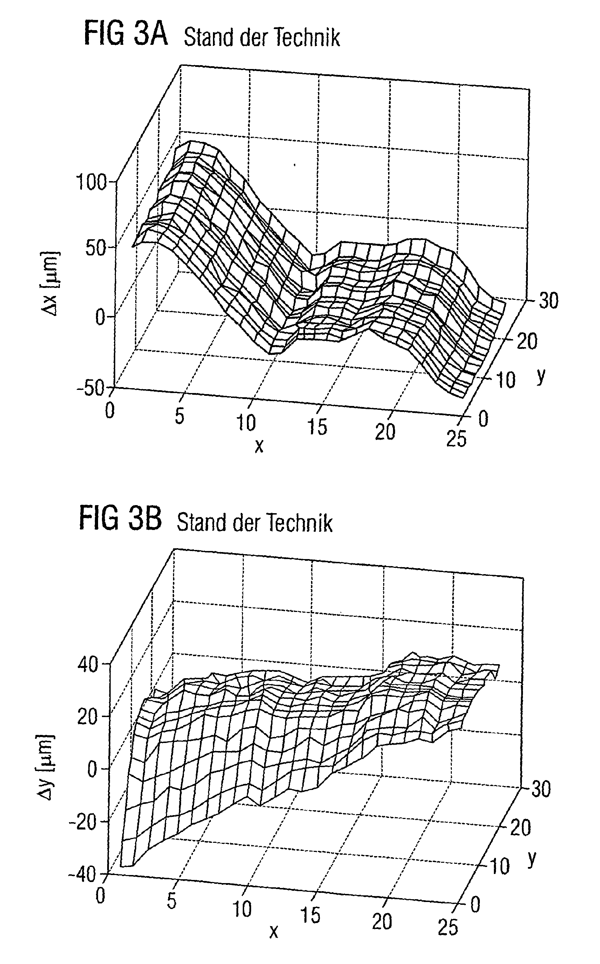

Die Figuren 3a und 3b zeigen gemeinsam die lokale Verzerrung der Flächen-Positioniervorrichtung in einer anderen Darstellung. Darin sind in einem dreidimensionalen Koordinatensystem jeweils als Funktion der X- und Y-Koordinate der jeweiligen Referenzmarke 101 die lokale Verzerrung Δx in X-Richtung (Figur 3a) und die lokale Verzerrung Δy in Y-Richtung (Figur 3b) aufgetragen. Die lokalen Verzerrungen in X-Richtung sind in einem Bereich von -50 µm bis 100 µm dargestellt. Die lokalen Verzerrungen in Y-Richtung sind in einem Bereich von - 40 µm bis +40 µm dargestellt. Die Skalierung der X-Achse und der Y-Achse in den beiden Figuren 3a und 3b ist durch das vorgegebene zweidimensionale Raster der Referenzmarken 101 bestimmt.

Die in Figur 3a und 3b dargestellten Werte für die lokalen Verzerrungen Δx in X-Richtung und Δy in Y-Richtung werden vor einem Bestückprozess an die Steuerung der Flächen-Positioniervorrichtung des Bestückautomaten übergeben, so dass die ermittelten lokalen Verzerrungen durch eine entsprechende Korrektur des Verfahrweges der Positioniervorrichtung kompensiert werden können.

Das oben beschriebene Verfahren zur Vermessung der Verzerrung einer Flächen-Positioniervorrichtung hat den Nachteil, dass für eine genaue räumliche Vermessung der Verzerrung eine Vielzahl von lokalen Verzerrungen gemessen werden muss. Da für jede lokale Verzerrung eine bestimmte Referenzmarke 101 erfasst werden muss und die Flächen-Positioniervorrichtung dazu jeweils an die entsprechende Position gefahren werden muss, benötigt das oben beschriebene Verfahren eine relativ lange Messzeit.

Der Erfindung liegt somit die Aufgabe zugrunde, ein Verfahren zur Vermessung der Verzerrung einer Flächen-Positioniervorrichtung zu schaffen, welches innerhalb einer kurzen Messzeit eine zuverlässige Bestimmung der Verzerrung einer Flächen-Positioniervorrichtung ermöglicht.

Diese Aufgabe wird gelöst durch ein Verfahren mit den Merkmalen des unabhängigen Anspruchs 1. Der Erfindung liegt die Erkenntnis zugrunde, dass sich die Verzerrungen der Flächen-Positioniervorrichtung entlang verschiedener Richtungen unabhängig überlagern. Durch eine geeignete vektorielle Superposition von ausgewählten lokalen Verzerrungen kann somit die Verzerrung der Flächen-Positioniervorrichtung an einer Vielzahl von Positionen berechnet werden. Somit ist es nicht mehr erforderlich die Verzerrung der Flächen-Positioniervorrichtung über den gesamten Bestückbereich zu vermessen. Das erfindungsgemäße Verfahren kann deshalb innerhalb einer relativ kurzen Messzeit durchgeführt werden, ohne dass dadurch die Genauigkeit der Vermessung reduziert wird.

Bei der vorteilhaften Weiterbildung gemäß Anspruch 2 verlaufen die erste Richtung und die zweite Richtung senkrecht zueinander. Somit definieren die beiden Richtungen ein kartesisches Koordinatensystem mit zwei Achsen, wobei die eine Achse üblicherweise als X-Achse und die andere Achse üblicherweise als Y-Achse bezeichnet wird.

Die Erfindung eignet sich gemäß Anspruch 3 zur Genauigkeitsbestimmung für einen Bestückautomaten, bei dem das Bestückfeld relativ zu dem Bestückautomaten ortsfest angeordnet ist. Bei derartigen Bestückautomaten wird in dem Bestückfeld ein mit Bauelementen zu bestückendendes Substrat angeordnet und die Bauelemente mittels des Bestückkopfes von einer Zuführeinrichtung zu einer Aufsetzposition auf dem Substrat transportiert.

Als Kamera wird gemäß Anspruch 4 bevorzugt eine an dem Bestückkopf des Bestückautomaten angebrachte Leiterplattenkamera verwendet. Dies hat den Vorteil, dass das erfindungsgemäße Verfahren an herkömmlichen Bestückautomaten durchgeführt werden kann, ohne dass spezielle mechanische Umbauten oder eine zusätzliche Kamera erforderlich sind.

Die Erfindung eignet sich gemäß Anspruch 7 ebenfalls zur Genauigkeitsbestimmung für einen Bestückautomaten, bei dem der Bestückkopf relativ zu dem Bestückautomaten ortsfest angeordnet ist. Die Flächen-Positioniervorrichtung wird bei derartigen Bestückautomaten wie beispielsweise sog. Chip-Shooter dazu verwendet, um ein mit Bauelementen zu bestückendes Substrat in einer Ebene zu bewegen, welche winklig und bevorzugt senkrecht zur Aufsetzrichtung des Bauelements liegt. Auf diese Weise können die Bauelemente jeweils an den gewünschten Positionen auf dem Substrat aufgesetzt werden.

Gemäß der vorteilhaften Weiterbildung nach Anspruch 9 sind die ersten und die zweiten Referenzmarken an einer Referenzplatte angebracht. Die Verwendung einer Referenzplatte hat den Vorteil, dass diese mit einer hohen Präzision gefertigt oder zumindest mit einer hohen Präzision vermessen werden kann und somit die Referenzpositionen, an denen die einzelnen Referenzmarken angebracht sind, sehr genau bestimmt sind.

Die Weiterbildung nach Anspruch 10 hat den Vorteil, dass die Referenzmarken auf einfache Weise mit hoher Präzision angeordnet werden können.

Gemäß Anspruch 12 kann die lokale Verzerrung auch an sog. Zwischengitterpositionen ermittelt werden. Dies hat den Vorteil, dass die lokalen Verzerrungen prinzipiell an jeder beliebigen Position des Bestückfeldes bestimmt werden können. Da für die Interpolation lediglich ein Rechenaufwand erforderlich ist, wird durch die Bestimmung der lokalen Verzerrungen an Zwischengitterpositionen die Messzeit, welche in erster Linie durch die Verfahrzeiten der Flächen-Positioniervorrichtung bestimmt wird, nicht größer.

Die Weiterbildung gemäß Anspruch 13 ist insbesondere für eine Berechnung der Verzerrung einer Flächen-Positioniervorrichtung innerhalb eines rechteckigen Bereiches geeignet. In diesem Fall erweist es sich als besonders vorteilhaft, wenn Referenzmarken vermessen werden, die an dem Rand des rechteckigen Bereiches angeordnet sind. Auf diese Weise werden die lokalen Verzerrungen jeweils an zwei gegenüberliegenden Kanten des rechteckigen Bereiches gemessen. Für die nachfolgende Berechnung der lokalen Verzerrung an einer bestimmten Stelle innerhalb des rechteckigen Bereiches wird die Genauigkeit der Berechnung erhöht, wenn die lokalen Verzerrungen von insgesamt vier Referenzmarken superpositioniert werden, wobei jeweils zwei der vier Referenzmarken an einander gegenüberliegenden Kanten des rechteckigen Bereichs angeordnet sind und die vier lokalen Verzerrungen entsprechend ihres Abstandes von der bestimmten Stelle gewichtet werden.

Die Verwendung einer Anpassungskurve gemäß den Ansprüchen 14 und 15 hat den Vorteil, dass das sog. Messrauschen, d.h. statistische Abweichungen der gemessenen lokalen Verzerrung vom real existierenden Wert, weitgehend eliminiert werden kann und damit die Präzision des Verfahrens zur Vermessung der Verzerrung einer Positioniervorrichtung erhöht wird.

Die Verwendung von Polynomen gemäß Anspruch 16 hat den Vorteil, dass die in Realität auftretenden Verzerrungen auf einfache Weise gut beschrieben werden können. Die Verwendung von Polynomen hat ferner den Vorteil, dass die Anpassungskurven mit einem relativ geringen Rechenaufwand bestimmt werden können. Die Ordnung der zur Anpassung verwendeten Polynome wird zweckmäßigerweise dadurch ermittelt, dass nacheinander zumindest eine Mehrzahl von Anpassungen durchgeführt wird, wobei die Ordnung der für die Anpassung vorgesehenen Polynome jeweils um eins erhöht wird. Die geeignete Polynomordnung ist in der Regel dann gefunden, wenn sich die aufsummierten Abweichungen zwischen den ermittelten lokalen Verzerrungen und den entsprechenden durch die jeweilige Anpassungskurve bestimmten Werten nicht mehr wesentlich erhöht.

Weitere Vorteile und Merkmale der vorliegenden Erfindung ergeben sich aus der nachfolgenden beispielhaften Beschreibung einer derzeit bevorzugten Ausführungsform.

### In der Zeichnung zeigen:

- Figur 1: eine Referenzplatte gemäß dem Stand der Technik,
- Figur 2: ein Fehlerresiduen-Feld, welches durch ein bekanntes Verfahren zur Vermessung der Verzerrung einer Flächen-Positioniervorrichtung ermittelt wurde,
- Figur 3a und Figur 3b: die lokale Verzerrung einer Flächen-Positioniervorrichtung in X- bzw. Y-Richtung, welche lokale Verzerrung mit dem bekannten Verfahren zur Vermessung der Verzerrung einer Flächen-Positioniervorrichtung ermittelt wurde,
- Figur 4a und Figur 4b: die lokalen Verzerrungen einer Flächen-Positioniervorrichtung in X- bzw. Y-Richtung am Rand eines Bereiches, welche lokalen Verzerrungen gemäß einem Ausführungsbeispiel der Erfindung zur Rekonstruktion der gesamten Verzerrung der Positioniervorrichtung verwendet werden, und
- Figur 5a und Figur 5b: die lokale Verzerrung der Flächen-Positioniervorrichtung in X- bzw. Y-Richtung im gesamten Positionierbereich der Positioniervorrichtung, welche auf Basis der in Figur 4a und 4b dargestellten Randdaten durch geeignete Superpositionen rekonstruiert wurde.

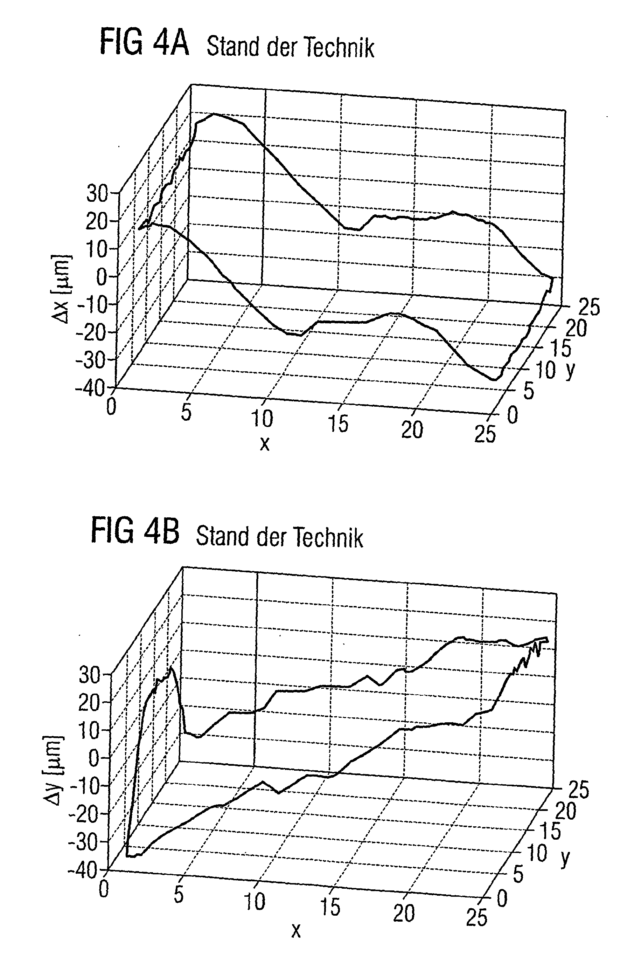

Die Figuren 4a und 4b zeigen, wie gemäß einem Ausführungsbeispiel der Erfindung die Randdaten eines bestimmten Bestückbereichs herangezogen werden, um die Verzerrung einer Flächen-Positioniervorrichtung über den gesamten Bestückbereich zu rekonstruieren. Die Randdaten werden gemäß dem hier beschriebenen Ausführungsbeispiel der Erfindung dadurch bestimmt, dass eine Vielzahl von Referenzmarken, welche am Rand des Bestückbereichs angeordnet sind, mittels einer am Bestückkopf angebrachten Kamera erfasst werden. Die Daten repräsentieren die lokalen Verzerrungen der Flächen-Positioniervorrichtung am Rand des Bestückbereichs, wobei sich jede lokale Verzerrung aus dem vektoriellen Abstand zwischen einer Messposition und einer Referenzposition ergibt. Die Messposition ergibt sich aus dem für die Erfassung der jeweiligen Referenzmarke erforderlichen Verfahrweges der Positioniervorrichtung, die Referenzposition ergibt sich aus der a priori bekannten räumlichen Lage der jeweils erfassten Referenzmarke. In Figur 4a ist jeweils die X-Komponente der an dem Randbereich bestimmten Verzerrung Δx in der Längeneinheit *µ*m dargestellt. In Figur 4b ist jeweils die Y-Komponente der an den Randbereich ermittelten lokalen Verzerrungen Δy in der Längeneinheit *µ*m dargestellt.

An dieser Stelle wird darauf hingewiesen, dass nach der Erfassung der lokalen Verzerrungen an dem Rand des Bestückbereichs die Randdaten außerdem durch eine Polynomapproximation angepasst werden können. Eine derartige Anpassung wurde bei dem hier beschriebenen Ausführungsbeispiel der Erfindung nicht vorgenommen. Im Falle der Verwendung einer Polynomapproximation werden für die Anpassung der lokalen Verzerrungen am Rand des Bestückbereiches in X- und in Y-Richtung jeweils vier Polynome verwendet, wobei die Randdaten an einander gegenüberliegenden Rändern bevorzugt durch Polynome mit gleicher Ordnung angepasst werden. Die Verwendung von Anpassungskurven hat den Vorteil, dass das Messrauschen erheblich reduziert werden kann.

Es wird ferner darauf hingewiesen, dass am Randbereich auch jeweils zwei parallele Zeilen von Referenzmarken vermessen werden können. Im Falle der Anpassung der Randdaten mittels einer Polynomapproximation werden die beiden Zeilen an einer Kante des Bestückbereichs dann gemeinsam mit einem einzigen Polynom angepasst. Die zweizeilige Randvermessung ist insbesondere bei der Messung der Verzerrung innerhalb eines kleinen Bestückbereiches sinnvoll, da auf diese Weise genug Messwerte für eine nachfolgende zuverlässige Rekonstruktion der Verzerrung im Inneren des kleinen Bestückbereiches zur Verfügung gestellt werden.

Es wird außerdem darauf hingewiesen, dass grundsätzlich eine Polynomapproximation auch über den gesamten Bestückbereich angewendet werden kann. In diesem Fall entfällt zwar der Vorteil einer kürzeren Messzeit für die Bestimmung der Verzerrung der Flächen-Positioniervorrichtung, der Vorteil der erheblichen Reduktion des Messrauschens bleibt aber erhalten.

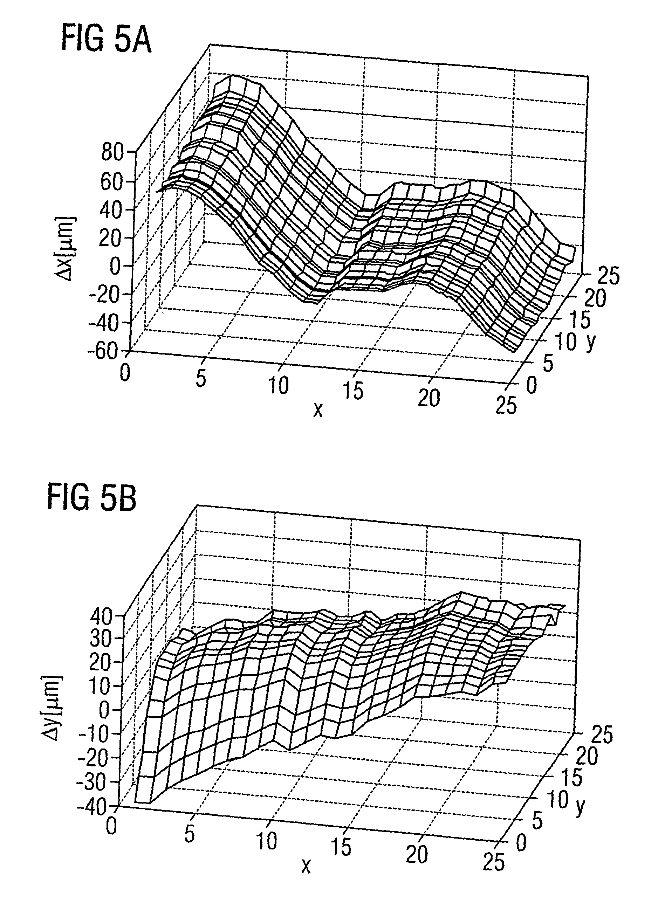

In den Figuren 5a und 5b ist die Verzerrung der Flächen-Positioniervorrichtung in dem gesamten Bestückfeld dargestellt, wobei die lokalen Verzerrungen im Innenbereich des Bestückfeldes ausschließlich durch die in den Figuren 4a und 4b dargestellten Randdaten rekonstruiert wurden. Wie aus einem Vergleich mit den in den Figuren 3a und 3b dargestellten lokalen Verzerrungen zu erkennen ist, ist der Verlauf der rekonstruierten Daten denen in den Figuren 3a und 3b dargestellten gemessenen Daten sehr ähnlich. Die Verzerrung der Flächen-Positioniervorrichtung kann somit unter der ausschließlichen Verwendung der Randdaten weitgehend ohne Informationsverlust rekonstruiert werden. Die in den Figuren 5a und 5b dargestellten rekonstruierten Daten haben gegenüber den in den Figuren 3a und 3b dargestellten gemessenen Daten den zusätzlichen Vorteil, dass das Messrauschen erheblich reduziert ist.

Da die Messzeit für das Verfahren gemäß dem hier beschriebenen Ausführungsbeispiel der Erfindung gegenüber den bekannten Verfahren zur Vermessung der Verzerrung einer Flächen-Positioniervorrichtung erheblich reduziert ist, kann der Randbereich des Bestückfeldes in einer höheren räumlichen Auflösung vermessen werden, ohne dass dadurch die gesamte Bestückleistung eines Bestückautomaten durch die mit der Verzerrungsvermessung verbundenen Standzeit erheblich reduziert wird. Die Messung der Randdaten mit einer höheren räumlichen Auflösung hat den Vorteil, dass die statistische Sicherheit des Verfahrens erhöht wird und gleichzeitig die Empfindlichkeit gegenüber Messrauschen verbessert wird. Ein weiterer Vorteil der Erfindung besteht darin, dass aufgrund der kurzen Messzeit die Verzerrung einer Flächen-Positioniervorrichtung eines Bestückautomaten in relativ kurzen Abständen gemessen werden kann und somit eine hohe Bestückgenauigkeit über einen langen Zeitraum gewährleistet werden kann, ohne die Standzeit des eingesetzten Bestückautomaten durch lang andauernde Messungen der Verzerrung wesentlich zu reduzieren.

Zusammenfassend schafft die Erfindung ein Verfahren zur Vermessung der Verzerrung einer Flächen-Positioniervorrichtung, welche insbesondere für einen Bestückautomaten vorgesehen ist, mittels welchem Bauelemente auf einer Leiterplatte oder auf einem Substrat bestückt werden können. Bei dem erfindungsgemäßen Verfahren wird mittels der Flächen-Positioniervorrichtung eine Relativbewegung zwischen einer Kamera und einem Bestückfeld erzeugt. Erfindungsgemäß werden nur lokale Verzerrungen an ausgewählten Positionen gemessen, indem jeweils der vektorielle Abstand zwischen der Position einer Referenzmarke 101, welche mittels der Kamera erfasst wird, und einer durch den entsprechenden Verfahrweg der Positioniervorrichtung bestimmten Messposition ermittelt wird. Die lokalen Verzerrungen an anderen Positionen werden durch jeweils eine geeignete Superposition von gemessenen lokalen Verzerrungen berechnet. Auf diese Weise kann die lokale Verzerrung über einen größeren Bestückbereich durch eine relativ geringe Anzahl von gemessenen lokalen Verzerrungen ohne Informationsverlust rekonstruiert werden. Bei der Rekonstruktion der lokalen Verzerrung in dem gesamten Bestückbereich kann zur Reduktion des Messrauschens eine Polynomapproximation verwendet werden.

## Patentansprüche

1. Verfahren zur Vermessung der Verzerrung einer Flächen-Positioniervorrichtung, insbesondere einer für einen Bestückautomaten verwendeten Positioniervorrichtung, bei dem
• mittels der Flächen-Positioniervorrichtung eine Relativbewegung zwischen einer Kamera und einem Bestückfeld eines Bestückautomaten erzeugt wird,
• mittels der Kamera entlang einer ersten Richtung erste Referenzmarken (101) erfasst werden, welche in dem Bestückfeld jeweils an einer genau festgelegten ersten Referenzposition angeordnet sind,
• durch eine Messung des für die Erfassung der ersten Referenzmarken (101) jeweils erforderlichen Verfahrwegs der Positioniervorrichtung jeweils eine erste Messposition ermittelt wird,
• an den ersten Referenzpositionen jeweils eine lokale Verzerrung ermittelt wird, indem der Abstand zwischen der jeweiligen ersten Referenzposition und der entsprechenden ersten Messposition vektoriell bestimmt wird,
• mittels der Kamera entlang einer zweiten Richtung zweite Referenzmarken (101) erfasst werden, welche in dem Bestückfeld des Bestückautomaten jeweils an einer genau festgelegten zweiten Referenzposition angeordnet sind,
• durch eine Messung des für die Erfassung der zweiten Referenzmarken (101) jeweils erforderlichen Verfahrwegs der Positioniervorrichtung jeweils eine zweite Messposition ermittelt wird,
• an den zweiten Referenzpositionen jeweils eine lokale Verzerrung berechnet wird, indem der Abstand zwischen der jeweiligen zweiten Referenzposition und der entsprechenden zweiten Messposition vektoriell bestimmt wird, **dadurch gekennzeichnet, dass**
• die lokale Verzerrung der Positioniervorrichtung für weitere Positionen des Bestückfeldes durch eine Superposition von zumindest der lokalen Verzerrung einer ersten Referenzmarke (101) und der lokalen Verzerrung einer zweiten Referenzmarke (101) berechnet wird, wobei die erste Referenzmarke (101) und die zweite Referenzmarke (101) derart ausgewählt werden, dass in einem durch die erste Richtung und durch die zweite Richtung definierten Koordinatensystem
- entlang der ersten Richtung die weitere Position und die erste Referenzmarke (101) die gleiche Koordinate haben und
- entlang der zweiten Richtung die weitere Position und die zweite Referenzmarke (101) die gleiche Koordinate haben.

2. Verfahren gemäß Anspruch 1, bei dem die erste Richtung und die zweite Richtung zueinander senkrecht verlaufen.

3. Verfahren gemäß einem der Ansprüche 1 bis 2, bei dem
• eine Flächen-Positioniervorrichtung mit einem entlang einer stationären Linearführung verfahrbaren, zu der Linearführung querstehenden Arm und einem entlang dem querstehenden Arm verfahrbaren Bestückkopf verwendet wird und
• die Kamera mittels der Positioniervorrichtung relativ zu dem Bestückfeld bewegt wird, welches relativ zu dem Bestückautomaten ortsfest angeordnet ist.

4. Verfahren gemäß Anspruch 3, bei dem die Kamera an dem Bestückkopf angebracht ist.

5. Verfahren gemäß einem der Ansprüche 3 bis 4, bei dem die erste Richtung durch die Längsachse der stationären Linearführung vorgegeben wird.

6. Verfahren gemäß einem der Ansprüche 3 bis 5, bei dem die zweite Richtung durch die Längsachse des querstehenden Arms vorgegeben wird.

7. Verfahren gemäß einem der Ansprüche 1 bis 2, bei dem
• das Bestückfeld mittels der Flächen-Positioniervorrichtung relativ zu einem an dem Bestückautomaten angebrachten Bestückkopf bewegt wird, und
• eine Kamera verwendet wird, welche relativ zu dem Bestückautomaten ortfest angeordnet ist.

8. Verfahren gemäß Anspruch 7, bei dem die Kamera an dem Bestückkopf angebracht ist.

9. Verfahren gemäß einem der Ansprüche 1 bis 8, bei dem eine Referenzplatte (100) verwendet wird, an welcher die ersten Referenzmarken (101) und die zweiten Referenzmarken (101) angebracht sind.

10. Verfahren gemäß einem der Ansprüche 1 bis 9, bei dem die ersten und die zweiten Referenzmarken (101) an Kreuzungspunkten eines zweidimensionalen Gitters angeordnet sind, welches sich über zumindest einen Teilbereich des Bestückfeldes erstreckt.

11. Verfahren gemäß Anspruch 10, bei dem die lokalen Verzerrungen der Positioniervorrichtung zumindest an einer Mehrzahl von Kreuzungspunkten des zweidimensionalen Gitters berechnet werden.

12. Verfahren gemäß einem der Ansprüche 1 bis 11, bei dem die lokale Verzerrung an einer beliebigen Position des Bestückfeldes durch eine Interpolation zwischen den lokalen Verzerrungen von zumindest zwei der beliebigen Position benachbarten Positionen berechnet wird.

13. Verfahren gemäß einem der Ansprüche 1 bis 12, bei dem erste und zweite Referenzmarken (101) erfasst werden, welche an dem Rand eines Bereiches angeordnet sind, welcher Bereich zumindest einen Teilbereich des gesamten Bestückfeldes darstellt.

14. Verfahren gemäß einem der Ansprüche 1 bis 13, bei dem
• für die Komponenten der lokalen Verzerrungen entlang der ersten Richtung an den ersten Referenzpositionen zumindest eine erste Anpassungskurve ermittelt wird und
• für die Komponenten der lokalen Verzerrungen entlang der ersten Richtung an den zweiten Referenzpositionen zumindest eine weitere erste Anpassungskurve ermittelt wird,
wobei die Werte der zumindest zwei ersten Anpassungskurven für die weitere Berechnung der Verzerrung der Positioniervorrichtung verwendet werden.

15. Verfahren gemäß Anspruch 14, bei dem
• für die Komponenten der lokalen Verzerrungen entlang der zweiten Richtung an den ersten Referenzpositionen zumindest eine zweite Anpassungskurve ermittelt wird und
• für die Komponenten der lokalen Verzerrungen entlang der zweiten Richtung an den zweiten Referenzpositionen zumindest eine weitere zweite Anpassungskurve ermittelt wird,
wobei die Werte der zumindest zwei zweiten Anpassungskurven für die weitere Berechnung der Verzerrung der Positioniervorrichtung verwendet werden.

16. Verfahren gemäß einem der Ansprüche 14 bis 15, bei dem für die Ermittlung der zumindest zwei ersten und/oder für die Ermittlung der zumindest zwei zweiten Anpassungskurven jeweils Polynome verwendet werden.

## Claims

1. Method for measuring the distortion of a surface positioning device, in particular of a positioning device used for an automatic component mounting machine, wherein
. a relative movement between a camera and a mounting field of an automatic component mounting machine is produced by means of the surface positioning device,
. first reference marks (101) are recorded along a first direction by means of the camera, said first reference marks (101) being disposed in the mounting field respectively at an accurately determined first reference position,
. a first measured position is determined respectively by means of a measurement of the travel path of the positioning device required respectively for the recording of the first reference marks (101),
. a local distortion is determined respectively at the first reference positions, by determining the distance between the respective first reference position and the corresponding first measured position in a vectorial manner,
• second reference marks (101) are determined along a second direction by means of the camera, said second reference marks (101) being disposed respectively in the mounting field of the automatic component mounting machine at an accurately established second reference position,
. a second measured position is determined respectively by means of a measurement of the travel path of the positioning device required respectively for the recording of the second reference marks (101),
. a local distortion is calculated respectively at the second reference positions, by determining the distance between the respective second reference position and the corresponding second measured position in a vectorial manner,
**characterised in that**
. the local distortion of the positioning device is calculated for further positions of the mounting field by means of a superposition of at least the local distortion of a first reference mark (101) and the local distortion of a second reference mark (101), with the first reference mark (101) and the second reference mark (101) being selected in such a manner that in a coordinate system defined by the first direction and by the second direction
- the further position and the first reference mark (101) have the same coordinate along the first direction and
- the further position and the second reference mark (101) have the same coordinate along the second direction.

2. Method according to claim 1, wherein the first direction and second direction run perpendicular to one another.

3. Method according to one of claims 1 to 2, wherein
.a surface positioning device with an arm that can be moved along a stationary linear guide and is at right angles to the linear guide and with a mounting head that can be moved along the perpendicular arm is used and
. the camera is moved by means of the positioning device in relation to the mounting field, which is disposed in a fixed manner in relation to the automatic component mounting machine.

4. Method according to claim 3, wherein the camera is attached to the mounting head.

5. Method according to one of claims 3 to 4, wherein the first direction is predetermined by the longitudinal axis of the stationary linear guide.

6. Method according to one of claims 3 to 5, wherein the second direction is predetermined by the longitudinal axis of the perpendicular arm.

7. Method according to one of claims 1 to 2, wherein
. the mounting field is moved by means of the surface positioning device in relation to a mounting head attached to the automatic component mounting machine and
. a camera is used, which is disposed in a fixed manner in relation to the automatic component mounting machine.

8. Method according to claim 7, wherein the camera is attached to the mounting head.

9. Method according to one of claims 1 to 8, wherein a reference plate (100) is used, to which the first reference marks (101) and the second reference marks (101) are applied.

10. Method according to one of claims 1 to 9, wherein the first and second reference marks (101) are disposed at crossing points of a two-dimensional grid, which extends over at least a sub-region of the mounting field.

11. Method according to claim 10, wherein the local distortions of the positioning device are calculated at least at a number of crossing points of the two-dimensional grid.

12. Method according to one of claims 1 to 11, wherein the local distortion is calculated at any position of the mounting field by means of an interpolation between the local distortions of at least two positions adjacent to said any position.

13. Method according to one of claims 1 to 12, wherein first and second reference marks (101) are recorded, which are disposed at the edge of a region, said region representing at least a sub-region of the entire mounting field.

14. Method according to one of claims 1 to 13, wherein
. at least a first adjustment curve is determined at the first reference positions for the components of the local distortions along the first direction and
. at least a further first adjustment curve is determined at the second reference positions for the components of the local distortions along the first direction,
with the values of the at least two first adjustment curves being used for the further calculation of the distortion of the positioning device.

15. Method according to claim 14, wherein
. at least a second adjustment curve is determined at the first reference positions for the components of the local distortions along the second direction and
. at least a further second adjustment curve is determined at the second reference positions for the components of the local distortions along the second direction,
with the values of the at least two second adjustment curves being used for the further calculation of the distortion of the positioning device.

16. Method according to one of claims 14 to 15, wherein polynomials are used respectively to determine the at least two first and/or to determine the at least two second adjustment curves.

## Revendications

1. Procédé pour mesurer la distorsion d'un dispositif de positionnement en surface, en particulier d'un dispositif de positionnement utilisé pour un automate de placement de composants, dans lequel
• on crée au moyen dudit dispositif de positionnement un mouvement relatif entre une caméra et un champ de placement de composants d'un automate de placement de composants,
• on détecte au moyen de ladite caméra, suivant une première direction, des premiers repères de référence (101) situés chacun dans ledit champ de placement de composants à une première position de référence définie avec précision,
• on détermine à chaque fois une première position de mesure en mesurant chaque déplacement nécessaire du dispositif de positionnement pour détecter lesdits premiers repères de référence (101),
• on mesure à chacune desdites premières positions de référence une distorsion locale, en déterminant vectoriellement la distance entre chaque première position de référence et la première position de mesure correspondante,
• on détecte au moyen de ladite caméra, suivant une seconde direction, des seconds repères de référence (101) situés chacun dans ledit champ de placement de composants de l'automate de placement de composants à une seconde position de référence définie avec précision,
• on détermine à chaque fois une seconde position de mesure en mesurant chaque déplacement nécessaire du dispositif de positionnement pour détecter lesdits seconds repères de référence (101),
• on calcule à chacune desdites secondes positions de référence une distorsion locale, en déterminant vectoriellement la distance entre chaque seconde position de référence et la seconde position de mesure correspondante,
**caractérisé en ce que**
• on calcule la distorsion locale du dispositif de positionnement pour d'autres positions du champ de placement de composants, en superposant au moins la distorsion locale d'un premier repère de référence (101) et la distorsion locale d'un second repère de référence (101), ledit premier repère de référence (101) et ledit second repère de référence (101) étant choisis de manière que dans un système de coordonnées défini par la première direction et la seconde direction,
- suivant la première direction, l'autre position et le premier repère de référence (101) aient les mêmes coordonnées, et
- suivant la seconde direction, l'autre position et le second repère de référence (101) aient les mêmes coordonnées.

2. Procédé selon la revendication 1, dans lequel la première direction et la seconde direction s'étendent perpendiculairement l'une à l'autre.

3. Procédé selon l'une des revendications 1 à 2, dans lequel
• on utilise un dispositif de positionnement en surface comprenant un bras déplaçable le long d'un guide linéaire stationnaire et perpendiculaire audit guide linéaire, et une tête de placement de composants déplaçable le long dudit bras perpendiculaire,
• on déplace la caméra, au moyen du dispositif de positionnement, relativement audit champ de placement de composants lequel est disposé de manière fixe par rapport à l'automate de placement de composants.

4. Procédé selon la revendication 3, dans lequel la caméra est fixée sur la tête de placement de composants.

5. Procédé selon l'une des revendications 3 à 4, dans lequel la première direction est imposée par l'axe longitudinal du guide linéaire stationnaire.

6. Procédé selon l'une des revendications 3 à 5, dans lequel la seconde direction est imposée par l'axe longitudinal du bras perpendiculaire.

7. Procédé selon l'une des revendications 1 à 2, dans lequel
• on déplace le champ de placement de composants, au moyen du dispositif de positionnement en surface, relativement à une tête de placement de composants fixée sur l'automate de placement de composants, et
• on utilise une caméra disposée de manière fixe par rapport à l'automate de placement de composants.

8. Procédé selon la revendication 7, dans lequel la caméra est fixée sur la tête de placement de composants.

9. Procédé selon l'une des revendications 1 à 8, dans lequel on utilise une plaquette de référence (100) sur laquelle sont placés les premiers repères de référence (101) et les seconds repères de référence (101).

10. Procédé selon l'une des revendications 1 à 9, dans lequel les premiers et les seconds repères de référence (101) sont placés aux points d'intersection d'une grille bidimensionnelle s'étendant au moins sur une partie du champ de placement de composants.

11. Procédé selon la revendication 10, dans lequel on calcule les distorsions locales du dispositif de positionnement au moins sur une pluralité de points d'intersection de la grille bidimensionnelle.

12. Procédé selon l'une des revendications 1 à 11, dans lequel on calcule la distorsion locale à une position arbitraire du champ de placement de composants, en interpolant entre les distorsions locales d'au moins deux positions voisines de la position arbitraire.

13. Procédé selon l'une des revendications 1 à 12, dans lequel on détecte des premiers et seconds repères de référence (101) placés au bord d'une zone, laquelle zone représente au moins une partie de la totalité du champ de placement de composants.

14. Procédé selon l'une des revendications 1 à 13, dans lequel
• on calcule pour les composantes des distorsions locales suivant la première direction, aux premières positions de référence, au moins une première courbe d'adaptation, et
• on calcule pour les composantes des distorsions locales suivant la première direction, aux secondes positions de référence, au moins une autre première courbe d'adaptation,
les valeurs desdites au moins deux premières courbes d'adaptation étant utilisées pour la poursuite du calcul de la distorsion du dispositif de positionnement.

15. Procédé selon la revendication 14, dans lequel
• on calcule pour les composantes des distorsions locales suivant la seconde direction, aux premières positions de référence, au moins une seconde courbe d'adaptation, et
• on calcule pour les composantes des distorsions locales suivant la seconde direction, aux secondes positions de référence, au moins une autre seconde courbe d'adaptation, les valeurs desdites au moins deux secondes courbes d'adaptation étant utilisées pour la poursuite du calcul de la distorsion du dispositif de positionnement.

16. Procédé selon l'une des revendications 14 à 15, dans lequel on utilise des polynômes pour le calcul desdites au moins deux premières et/ou pour le calcul desdites au moins deux secondes courbes d'adaptation.
